(19) **Europäisches Patentamt / European Patent Office / Office européen des brevets**

(11) **EP 4 675 503 A1**

(12) **EUROPEAN PATENT APPLICATION**

(43) Date of publication:
07.01.2026 Bulletin 2026/02

(51) International Patent Classification (IPC):
*G06N 3/049* (2023.01)    *B65H 67/06* (2006.01)
*B65H 67/04* (2006.01)

(21) Application number: 25183663.1

(22) Date of filing: 18.06.2025

(52) Cooperative Patent Classification (CPC):
**G06N 3/049; B65H 67/0411; B65H 67/064;**
B65H 2701/31; Y02P 90/30

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 04.07.2024 CN 202410898010

(71) Applicants:
• Zhejiang Hengyi Petrochemical Co., Ltd.
Zhejiang 311200 (CN)
• Zhejiang Shuangtu New Materials Co., Ltd.
Hangzhou, Zhejiang 311255 (CN)

(72) Inventors:
• PENG, Xiantao
Hangzhou 311200 (CN)

• WANG, Peng
Hangzhou 311200 (CN)
• QIU, Yibo
Hangzhou 311200 (CN)
• LI, Dake
Hangzhou 311200 (CN)
• JIN, Junliang
Hangzhou 311200 (CN)
• JIANG, Dong
Hangzhou 311200 (CN)
• WANG, Jian
Hangzhou 311200 (CN)
• LI, Weike
Hangzhou 311200 (CN)

(74) Representative: Bittner, Bernhard
Hannke Bittner & Partner
Patent- und Rechtsanwälte mbB
Prüfeninger Strasse 1
93049 Regensburg (DE)

(54) **METHOD AND APPARATUS FOR PLANNING DOFFING PATH, DEVICE AND STORAGE MEDIUM**

(57) A method and an apparatus for planning a doffing path, and a storage medium are provided, relating to the field of computer technology and the field of path planning technology. The method includes: constructing (S101) a road network topology structure according to positions of winders to be doffed, the road network topology structure including winder nodes, and one winder node corresponding to one winder; determining (S102) neurons in a DSPCNN according to the winder nodes, one winder node corresponding to one neuron; selecting (S103) a source neuron and a target neuron from the neurons; performing (S104) ignition calculation according to the source neuron and the target neuron to obtain a first path corresponding to the source neuron and a second path corresponding to the target neuron; and determining (S105) a doffing path of a winder node in the road network topology structure according to the first and second paths.

S101
Constructing a road network topology structure according to positions of a plurality of winders to be doffed, where the road network topology structure includes a plurality of winder nodes, and one winder node corresponds to one winder

S102
Determining a plurality of neurons in a dual source pulse coupled neural network according to the plurality of winder nodes in the road network topology structure, where one winder node corresponds to one neuron

S103
Selecting a source neuron and a target neuron from the plurality of neurons in the DSPCNN

S104
Performing ignition calculation according to the source neuron and the target neuron to obtain a first path corresponding to the source neuron and a second path corresponding to the target neuron

S105
Determining a doffing path of a winder node in the road network topology structure according to the first path and the second path

FIG. 1

Processed by Luminess, 75001 PARIS (FR)

**Description**

TECHNICAL FIELD

The present disclosure relates to the field of computer technology, and in particular to the field of path planning technology.

BACKGROUND

In the winding workshop, after the winding of a yarn spindle on one chuck shaft of a winder is completed, the winder automatically switches to another chuck shaft to continue the winding task. At this time, if the yarn spindles on the full tube of yarn roller cannot be doffed in time, the tube will burst, causing the winder to stop working, and in severe cases, causing damage to the winder. Subsequently the winder needs to be cleaned before the winder can start working again, thereby leading to reduced production capacity.

SUMMARY

The invention is set out in the appended set of claims.

BRIEF DESCRIPTION OF THE DRAWINGS

In the accompanying drawings, the same reference numbers represent the same or similar parts or elements throughout the accompanying drawings, unless otherwise specified. These accompanying drawings are not necessarily drawn to scale. It should be understood that these accompanying drawings only depict some embodiments provided according to the present disclosure, and should not be considered as limiting the scope of the present disclosure.

FIG. 1 is a schematic flow chart of a method for planning a path according to an embodiment of the present disclosure;
FIG. 2 is a structural schematic diagram of a neuron in a DSPCNN according to an embodiment of the present disclosure;
FIG. 3 is a schematic diagram of path backtracking according to an embodiment of the present disclosure;
FIG. 4 is a schematic flow chart of a method for planning a path according to another embodiment of the present disclosure;
FIG. 5 is a schematic flow chart of a method for planning a path according to another embodiment of the present disclosure;
FIG. 6 is a schematic flow chart of a method for planning a path according to another embodiment of the present disclosure;
FIG. 7 is a schematic flow chart of a method for planning a path according to another embodiment of the present disclosure;
FIG. 8 is a schematic flow chart of a method for planning a path according to another embodiment of the present disclosure;
FIG. 9 is a specific structural diagram of a neuron in the DSPCNN according to an embodiment of the present disclosure;
FIG. 10 is a schematic diagram of an algorithm flow for searching the shortest path according to an embodiment of the present disclosure;
FIG. 11 is a structural schematic diagram of an apparatus for planning a doffing path according to an embodiment of the present disclosure;
FIG. 12 is a structural schematic diagram of an apparatus for planning a doffing path according to another embodiment of the present disclosure; and
FIG. 13 is a block diagram of an electronic device for implementing the embodiments of the present disclosure.

DETAILED DESCRIPTION

The present disclosure will be described below in detail with reference to the accompanying drawings. The same reference numbers in the accompanying drawings represent elements with identical or similar functions. Although various aspects of the embodiments are shown in the accompanying drawings, the accompanying drawings are not necessarily drawn to scale unless specifically indicated.

In addition, in order to better illustrate the present disclosure, numerous specific details are given in the following specific implementations. Those having ordinary skill in the art should understand that the present disclosure may be performed without certain specific details. In some examples, methods, means, elements and circuits well known to those having ordinary skill in the art are not described in detail, in order to highlight the subject matter of the present disclosure.

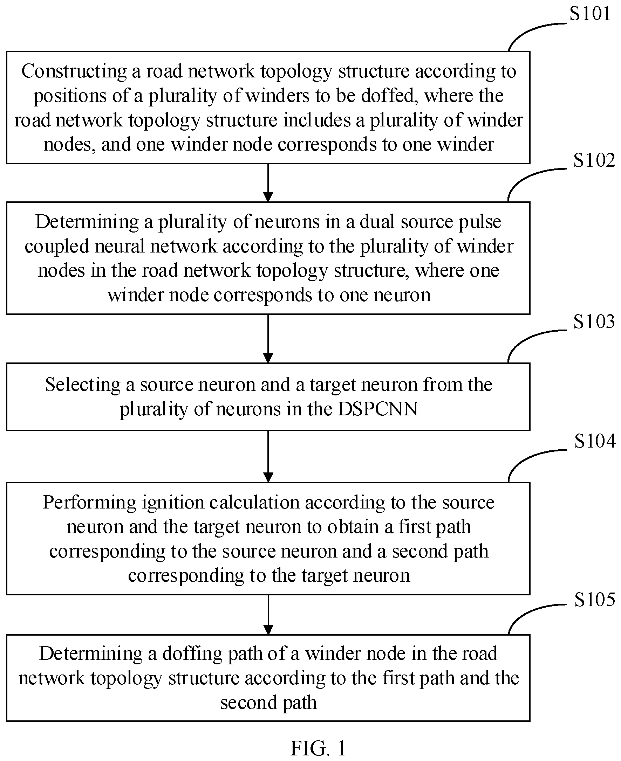

FIG. 1 is a schematic flow chart of a method for planning a path according to an embodiment of the present disclosure. The method includes:

S101: constructing a road network topology structure according to positions of a plurality of winders to be doffed, where the road network topology structure includes a plurality of winder nodes, and one winder node corresponds to one winder;

S102: determining a plurality of neurons in a Dual Source Pulse Coupled Neural Network (DSPCNN) according to the plurality of winder nodes in the road network topology structure, where one winder node corresponds to one neuron;

S103: selecting a source neuron and a target neuron from the plurality of neurons in the DSPCNN;

S104: performing ignition calculation according to the source neuron and the target neuron to obtain a first path corresponding to the source neuron and a second path corresponding to the target neuron; and

S105: determining a doffing path of a winder node in the road network topology structure according to the first path and the second path.

In an embodiment of the present disclosure, there may be a plurality of winders to be doffed during certain time periods in a winding operation area such as a winding workshop. The road network topology structure of the winders may be generated based on the positions of the winders, the travel paths between the winders, and other information. The road network topology structure may include a plurality of winder nodes, and one winder node may represent one winder. The properties of a winder node (also called doffing coordinate point) may include the coordinates, identifier, and connection path of this node. Specifically, the coordinates of the winder node in the road network topology structure may be determined according to the actual position of the winder, the identifier of the winder node in the road network topology structure may be determined according to the serial number of the winder, the connection path between the winder nodes may be determined according to the actual path between the winders, and the length of the connection path between the winder nodes in the road network topology structure may be determined according to the length of the path between the winders. In one example, the road network topology structure may include nodes corresponding to all winders in the winding workshop. In another example, the road network topology structure may include nodes corresponding to a plurality of winders to be doffed in the winding workshop.

In an embodiment of the present disclosure, the plurality of winders to be doffed in the winding workshop may be determined according to the position of a person or device that can perform the doffing task, the working states of the winders, and other information. The plurality of nodes corresponding to the plurality of winders to be doffed in the road network topology structure can be considered as nodes that need path planning.

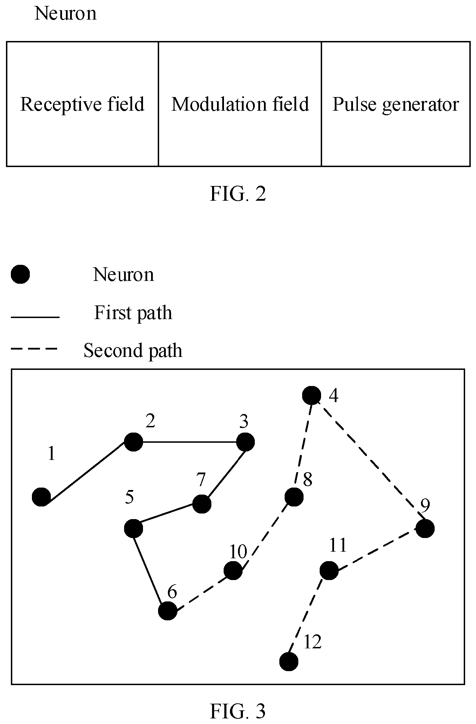

In an embodiment of the present disclosure, there may be many (for example, thousands of) winder nodes (doffing coordinate points) corresponding to the winders in a workshop, and the Dual Source Pulse Coupled Neural Network (DSPCNN) may be used for planning the doffing path. The DSPCNN includes a plurality of neurons. A neuron may be ignited and send pulse signals to its neighboring neurons, and may also receive pulse signals from its neighboring neurons. In the DSPCNN, two pulse signals from different ignition sources may propagate in parallel until the two pulse signals meet. In the DSPCNN, after a neuron is ignited, the neuron continuously sends pulse signals to other neurons through connection channels at the same frequency, and each time a pulse signal is sent is recorded as one moment. An example of the structure of a neuron in the DSPCNN is shown in FIG. 2. The neuron may include a receptive field, a modulation field, and a pulse generator.

In an embodiment of the present disclosure, the DSPCNN may be initialized based on the road network topology structure of the winders. When the DSPCNN is initialized, one winder node may be initialized as one neuron in the DSPCNN, and the properties of the neuron may be initialized based on the properties of the winder node. The properties of the neuron may include an identifier, a connection channel, an internal activity value, an internal activity value increment, an internal activity threshold, a state, etc. Specifically, the identifier of the corresponding neuron may be generated according to the identifier of the winder node, the connection channel between neurons may be generated according to the connection path between winder nodes, and the internal activity threshold of the corresponding neuron may be determined according to the length of the connection path between winder nodes. The internal activity value of the neuron may be initialized to 0 or any other numerical value, and may be calculated based on the internal activity value increment at the previous moment and the internal activity value at the previous moment. The internal activity value increment of the neuron may be initialized to be greater than 0, and the internal activity value increment may be determined according to the difference between the internal activity values of the neuron at adjacent moments during ignition. After receiving an externally input pulse signal, the neuron may change the internal activity value or internal activity value increment. The states of neurons may include ready-to-ignite, ignition, and/or shut-down, etc. In the initialized DSPCNN, one neuron may correspond to one winder in the doffing area.

In an embodiment of the present disclosure, after the initial DSPCNN is obtained, one source neuron and one target neuron may be selected from a plurality of neurons included in the initial DSPCNN. The source neuron and the target neuron correspond to different winders respectively. The source neuron and the target neuron may be set to the ignition state respectively, and the source neuron and the target neuron may respectively send out autowaves, which may also be called pulse signals. The autowave sent by the source neuron may be called a source pulse signal, and the autowave sent by the target neuron may be called a target pulse signal. In the DSPCNN, after receiving the source pulse signal or target pulse signal, one neuron may ignite itself and continue to send a pulse signal according to the source pulse signal or target pulse signal. For example, the neuron 2 is in the ready-to-ignite state; and upon receiving a source pulse signal from the neuron 1, the neuron 2 may be ignited and send pulse signals to other adjacent neurons such as neuron 3 and neuron 4.

When a neuron performs ignition, the neuron may obtain a pulse signal received from a previous neuron, and calculate the internal activity threshold at the current moment in combination with the connection channel between the neuron and the previous neuron. When the internal activity threshold is greater than the set value, such as 0, the neuron is ignited. The ignited neuron may calculate the internal activity value at the current moment according to the internal activity value of the neuron at the previous moment, the internal activity value increment and the external input (for example, including the pulse signal transmitted by the previous neuron and the preset input signal, etc.). The neuron is set to the ignition state to complete the ignition operation. Also, when the internal activity value at the current moment is not less than the internal activity threshold of the neuron, a pulse signal is calculated by using the internal activity value at the current moment and the internal activity threshold, and the pulse signal is sent to a next neuron. The ignited neuron may no longer process pulse signals sent by other neurons. The ignited neuron may send out pulse signals at a certain frequency. If a neuron receives a source pulse signal and a target pulse signal at the same time, it means that the two waves (source pulse signal and target pulse signal) meet in the same neuron. In this case, the neuron may ignite itself and then stop sending pulse signals, and the neuron is set to the shut-down state, so that the neuron shuts down, and then no new pulse signal is generated in the DSPCNN, and the internal activities of the DSPCNN stop. The neuron after shutting down may not send out pulse signals. The neuron after shutting down may no longer process pulse signals sent by other neurons.

In an embodiment of the present disclosure, after the neuron where the source pulse signal and the target pulse signal meet (referred to as the meeting neuron) shuts down, the relationship between precursor and successor in the ignition process is backtracked according to the pulse signal and the meeting neuron. The first path may be obtained by backtracking from the meeting neuron to the source neuron, and the second path may be obtained by backtracking from the meeting neuron to the target neuron. A doffing path may be obtained by combining the neurons included in the first path and the second path. FIG. 3 is a schematic diagram of path backtracking according to an example of the present disclosure. As shown in FIG. 3, the DSPCNN includes 12 neurons. During the ignition process, the neuron 1 is set as the source neuron, the neuron 12 is set as the target neuron, and the neuron 6 is the neuron where pulse signals meet. The first path is obtained by backtracking from neuron 6 to neuron 1, and the second path is obtained by backtracking from neuron 6 to neuron 12. Based on the ignition process of the DSPCNN, each neuron in the DSPCNN may be traversed, and then each winder to be doffed may be traversed, making the generated doffing path more complete, so that the doffing task can be performed on the winders to be doffed in time, reducing or even avoiding tube burst of yarn spindles on the winders.

According to the embodiment of the present disclosure, the doffing paths of the winders to be doffed are obtained based on the DSPCNN, improving the efficiency in generating the doffing paths, and thus improving the efficiency in executing the doffing task.

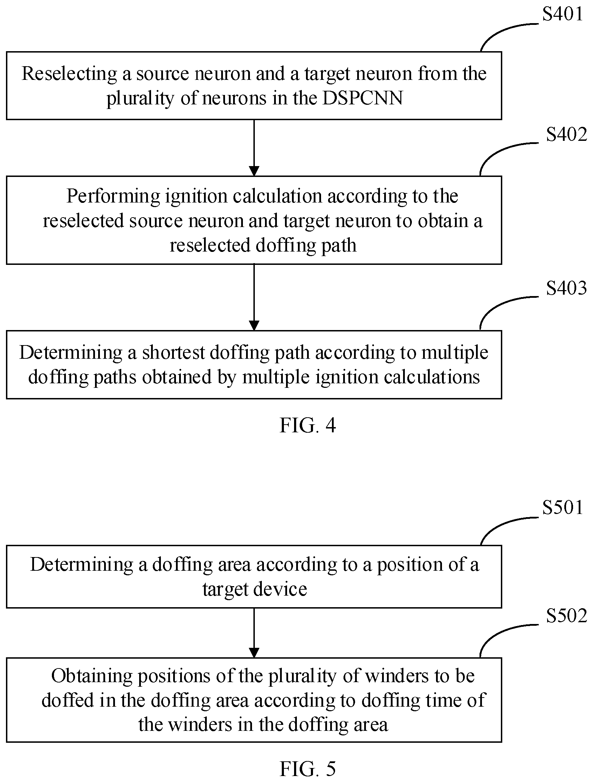

FIG. 4 is a schematic flow chart of a method for planning a path according to another embodiment of the present disclosure. This method may include one or more features of the above-mentioned method for planning the path. In one implementation, this method may further include:

S401: reselecting a source neuron and a target neuron from the plurality of neurons in the DSPCNN;
S402: performing ignition calculation according to the reselected source neuron and target neuron to obtain a reselected doffing path; and
S403: determining a shortest doffing path according to multiple doffing paths obtained by multiple ignition calculations.

In an embodiment of the present disclosure, after completing one ignition calculation, the DSPCNN may record the path obtained by the last ignition calculation, and reselect a source neuron and a target neuron different from those at this time from the DSPCNN to perform the ignition calculation again. At least one of the reselected source neuron and target neuron may be different from the last selected neuron.

In an embodiment of the present disclosure, the process of obtaining the reselected doffing path by ignition calculation in S402 is similar to S103 and S104. For example, when reselecting the source neuron and the target neuron to perform the ignition calculation again, a new first path and a new second path may be obtained based on the new source neuron and the new target neuron, and a new doffing path may be obtained by combining the new first path and the new second path.

In an embodiment of the present disclosure, S401 and S402 may be executed in a loop for multiple times. There are many ways to exit the loop, for example, a threshold of the quantity of ignitions is set, and the current quantity of ignitions in the DSPCNN is recorded each time the source neuron and/or target neuron is/are ignited. When the quantity of ignitions reaches the threshold of the quantity of ignitions, re-ignition is stopped. Then, the recorded information of all doffing paths, such as lengths of doffing paths and/or the estimated doffing durations, may be compared, and one path may be selected as the shortest doffing path. For example, the doffing path with the shortest length may be selected as the shortest doffing path. For another example, the path corresponding to the shortest estimated doffing duration may be selected as the shortest doffing path.

In an embodiment of the present disclosure, the doffing paths obtained after the ignitions for the DSPCNN are finished may be screened. It may be determined whether the doffing path currently obtained by ignition can be retained according to the comparison result between the estimated completion duration of the doffing task for the doffing path and the limited execution duration of the doffing task. The estimated completion duration of the doffing task may be determined according to the operating speed of the target device and the total length of any one of the above-mentioned doffing paths. The limited execution duration of the doffing task may be determined according to the difference between the doffing time of the earliest doffing task in the doffing area and the current time. The path length of the doffing path may be calculated according to the sum of the connection channels of the precursor and successor neurons in this path. For example, the limited execution duration of the doffing task is 10 minutes, the operating speed of the target device is 0.2 m/s (meters per second), the length of the doffing path is 400 m (meters), and the estimated completion duration of the doffing task is calculated as 2000 s (seconds), which exceeds the limited duration, so the current doffing path is discarded. For another example, the limited execution duration of the doffing task is 600 s, the operating speed of the target device is 0.2 m/s, the length of the doffing path is 100 m, and the estimated completion duration of the doffing task is calculated as 500 s, which is less than the limited duration, so the current doffing path is retained.

In an embodiment of the present disclosure, after the shortest doffing path is obtained, the shortest doffing path may be sent to the target device. The target device may include a Personal Digital Assistant (PDA) of a workshop staff, a humanoid robot, an Automated Guided Vehicle (AGV), and other devices related to doffing. The target device automatically executes the automatic doffing task or notifies the related personnel to execute the automatic doffing task according to the shortest doffing path. When the target device is a PDA of a workshop staff, the staff may be guided to perform the doffing task in the order of doffing paths; when the target device is a humanoid robot or an AGV in the workshop, the humanoid robot or AGV may perform the automatic doffing task according to the shortest doffing path.

According to the embodiment of the present disclosure, the doffing paths obtained by multiple ignitions can be compared to obtain the shortest doffing path, thereby improving the efficiency in executing the doffing task.

FIG. 5 is a schematic flow chart of a method for planning a path according to another embodiment of the present disclosure. This method may include one or more features of the above-mentioned method for planning the path. In one implementation, this method may further include:

S501: determining a doffing area according to a position of a target device; and
S502: obtaining positions of the plurality of winders to be doffed in the doffing area according to doffing time of the winders in the doffing area.

In an embodiment of the present disclosure, one workshop may include a plurality of target devices, and each target device may be responsible for the doffing work in a part of the workshop. The doffing area and the winders to be doffed in the area may be updated at regular intervals according to the states of the winders in the workshop.

In an embodiment of the present disclosure, the area in which the target device is responsible for doffing (referred to as doffing area) may be obtained according to the target device, and the state of each winder in the area is obtained. The information such as serial numbers of the winders to be doffed in the area is obtained according to the doffing time of the winders in the doffing area, and then the positions of the winders to be doffed are determined according to the serial numbers of the winders. The plurality of nodes in the road network topology structure may be determined according to the positions of the winders to be doffed, and the plurality of neurons in the DSPCNN may be further generated according to the plurality of nodes.

According to the embodiment of the present disclosure, the positions of the winders to be doffed are determined according to the doffing area corresponding to the target device, reducing the amount of data to be processed and improving the efficiency of the doffing task.

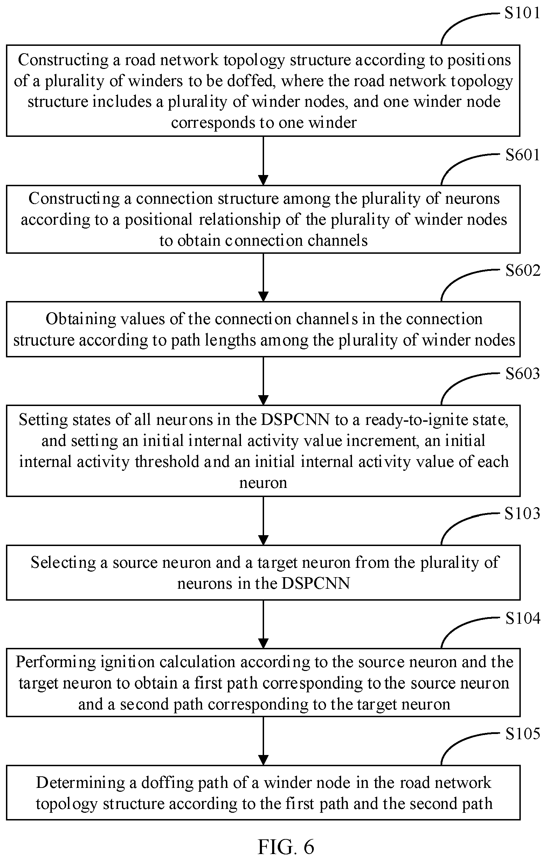

FIG. 6 is a schematic flow chart of a method for planning a path according to another embodiment of the present disclosure. This method may include one or more features of the above-mentioned method for planning the path. In one implementation, S102 of determining a plurality of neurons in the DSPCNN according to the plurality of winder nodes in the road network topology structure may include:

S601: constructing a connection structure among the plurality of neurons according to a positional relationship of the plurality of winder nodes to obtain connection channels;
S602: obtaining values of the connection channels in the connection structure according to path lengths among the plurality of winder nodes; and

S603: setting states of all neurons in the DSPCNN to a ready-to-ignite state, and setting an initial internal activity value increment, an initial internal activity threshold and an initial internal activity value of each neuron.

In an embodiment of the present disclosure, the connection structure among the plurality of neurons may be constructed in the DSPCNN according to the positional relationship of the winder nodes in the road network topology structure. The connection structure may be a full connection structure, or a connection structure that conforms to the connection paths among the winder nodes in the road network topology structure. A connection channel is constructed for each neuron, and the attributes of the connection channel include serial number and value. The serial number of the connection channel may be determined according to the identifiers of the precursor neuron and the successor neuron, and the value of the connection channel may be determined according to the path length between two winder nodes corresponding to two neurons connected by the connection channel in the winding area.

In an embodiment of the present disclosure, in the initial state, all neurons in the DSPCNN are in the ready-to-ignite state, and the internal activity of the DSPCNN is in the stop state. Each neuron in the DSPCNN has an initial internal activity value, an initial internal activity value increment, and an initial internal activity threshold. For example, the initial internal activity value of each neuron may be set to 0, the initial internal activity value increment may be set to be greater than 0, and the initial internal activity threshold may be set to a large constant or may be set according to the length of the connection path between winder nodes.

According to the embodiment of the present disclosure, the corresponding DSPCNN can be constructed according to the actual situation of the doffing area, and the calculation of the DSPCNN is associated with the actual situation, improving the availability of the doffing path in production.

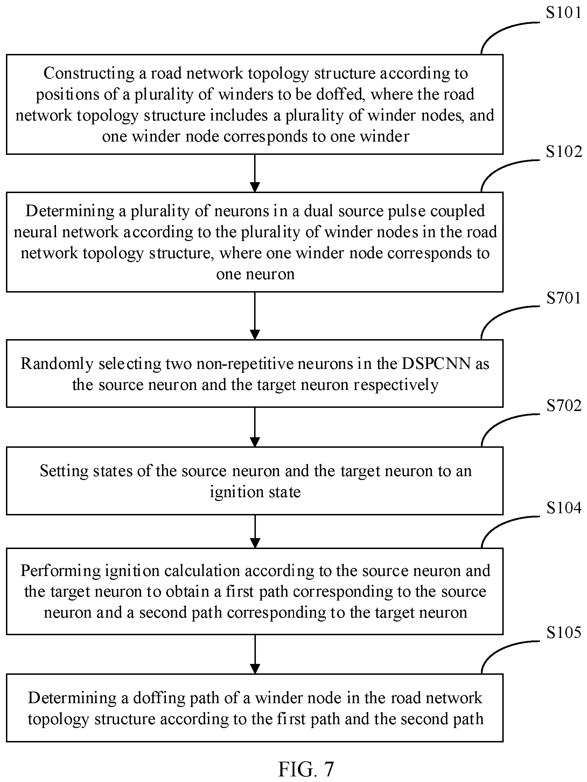

FIG. 7 is a schematic flow chart of a method for planning a path according to another embodiment of the present disclosure. This method may include one or more features of the above-mentioned method for planning the path. In one implementation, S103 of selecting a source neuron and a target neuron in the DSPCNN includes:

S701: randomly selecting two non-repetitive neurons in the DSPCNN as the source neuron and the target neuron respectively; and

S702: setting states of the source neuron and the target neuron to an ignition state.

In the embodiment of the present disclosure, when the pulse ignition is performed, two non-repetitive neurons may be arbitrarily selected in the DSPCNN as the source neuron and the target neuron of the dual source ignition. The two non-repetitive neurons may correspond to two winders in different positions. In the initial state, all neurons in the DSPCNN are in the ready-to-ignite state and do not send pulse signals outward. When a neuron is set as the source neuron or target neuron, the neuron changes its own state to the ignition state. When a neuron is in the ignition state, the neuron may send a pulse signal outward.

In the embodiment of the present disclosure, multiple ignition operations may be performed. After one DSPCNN ignition is completed, the source neuron and the target neuron may be reselected in the current DSPCNN for another ignition. At least one of the reselected source neuron and target neuron may be different from the last selected neuron.

According to the embodiment of the present disclosure, the DSPCNN can start ignition, and two different neurons are used for ignition, shortening the overall running time of the DSPCNN and improving the calculation efficiency.

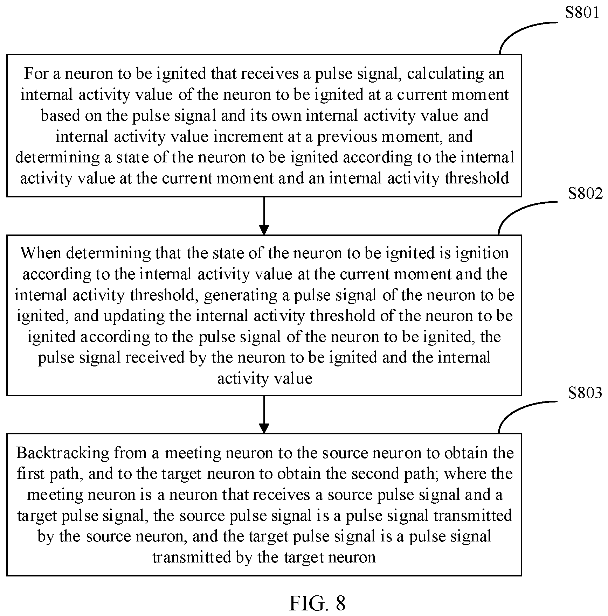

FIG. 8 is a schematic flow chart of a method for planning a path according to another embodiment of the present disclosure. This method may include one or more features of the above-mentioned method for planning the path. In one implementation, S104 of performing ignition calculation according to the source neuron and the target neuron to obtain a first path corresponding to the source neuron and a second path corresponding to the target neuron includes:

S801: for a neuron to be ignited that receives a pulse signal, calculating an internal activity value of the neuron to be ignited at a current moment based on the pulse signal and its own internal activity value and internal activity value increment at a previous moment, and determining a state of the neuron to be ignited according to the internal activity value at the current moment and an internal activity threshold;

S802: when determining that the state of the neuron to be ignited is ignition according to the internal activity value at the current moment and the internal activity threshold, generating a pulse signal of the neuron to be ignited, and updating the internal activity threshold of the neuron to be ignited according to the pulse signal of the neuron to be ignited, the pulse signal received by the neuron to be ignited and the internal activity value; and

S803: backtracking from a meeting neuron to the source neuron to obtain the first path, and to the target neuron to obtain the second path; where the meeting neuron is a neuron that receives a source pulse signal and a target pulse signal, the source pulse signal is a pulse signal transmitted by the source neuron, and the target pulse signal is a pulse signal transmitted by the target neuron.

In the embodiment of the present disclosure, when the source neuron or target neuron in the DSPCNN is ignited, it is necessary to firstly set the state of the source neuron or target neuron to the ignition state. The source neuron sends out the source pulse signal, and the target neuron sends out the target pulse signal. The neuron to be ignited that receives the source pulse signal calculates the internal activity value at the current moment according to the received source pulse signal, the external input signal, the internal activity value increment, and the internal activity value at the previous moment; and determines whether the ignition is required according to the internal activity value at the current moment and the internal activity threshold. If the ignition is required, the source pulse signal is sent out. The neuron to be ignited that receives the target pulse signal calculates the internal activity value at the current moment according to the received target pulse signal, the external input signal, the internal activity value increment, and the internal activity value at the previous moment; and determines whether the ignition is required according to the internal activity value at the current moment and the internal activity threshold. If the ignition is required, the target pulse signal is sent out. The neuron to be ignited that receives the source pulse signal and the target pulse signal is the meeting neuron. The internal activity value at the current moment and the internal activity threshold are calculated according to the received source pulse signal, the received target pulse signal, the external input signal, the internal activity value increment, and the internal activity value at the previous moment. But the meeting neuron may not send out pulse signals.

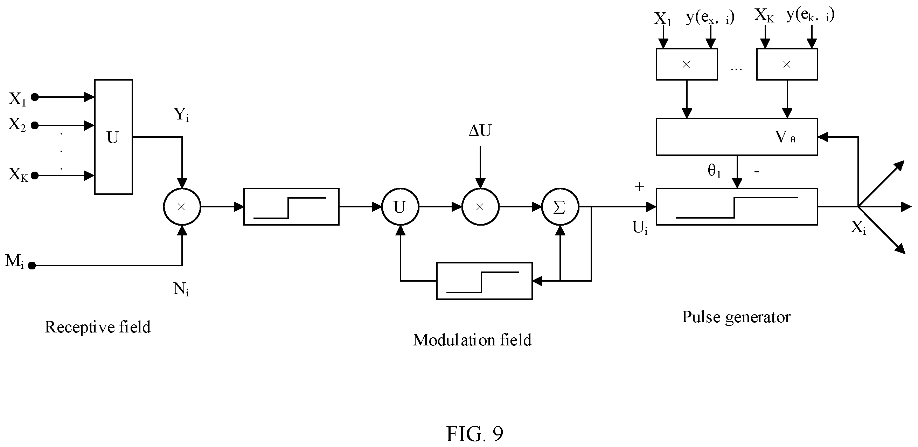

An exemplary structure of a neuron in the DSPCNN is shown in FIG. 9. The receptive field of the neuron may receive pulse signals $X_1$ to $X_K$ from neighboring neurons through connection channels to obtain an input pulse signal $Y_i$. The receptive field may also receive an external input $N_i$ introduced by the feeding terminal. $N_i$ may be generated according to an external input signal $M_i$. The modulation field may control the internal activity of the neuron and then control the state of the neuron according to the signals received by the receptive field. For example, the internal activity value $U_i$ is calculated according to the internal activity value increment $\Delta U$. Based on the internal activity value and the internal activity threshold $\theta_i$ of this neuron, it can be judged whether this neuron is ignited. If ignition is required, the pulse generator of this neuron may generate a pulse signal $X_i$ according to the internal activity value of the neuron calculated in the modulation field, and send the generated pulse signal to other adjacent neurons. Also, the pulse generator may calculate and update its own internal activity threshold $\theta_i$ according to its own pulse signal $X_i$ and the pulse signals $X_1$ to $X_K$ of neighboring neurons, the externally input connection channel value y(e), and its own internal activity value increment $\Delta U$. Here, $V_\theta$ may be the initial internal activity threshold.

Specifically, any neuron in the DSPCNN has parameters such as $M_i$, $Y_i$, $U_i$, $\Delta U$, $X_i$, $\theta_i$, $V_\theta$ and $N_i$. For the source neuron and the target neuron, their output pulse signals are set to 1 respectively, and transmitted to neighboring neurons to be ignited. For example, for one DSPCNN including 32 neurons, the neurons are numbered 0 to 31 respectively. If the neuron numbered 2 is selected as the source neuron and the neuron numbered 27 is selected as the target neuron, then $X_2[0] = 1$ and $X_{27}[0] = 1$ are set respectively, indicating that the source neuron and the target neuron are ignited; if the neighboring neuron of the neuron 2 is the neuron 4, then $X_2[0] = 1$ is transmitted to the neuron 4 through the connection channel; and similarly, if the neighboring neuron of the neuron 27 is the neuron 10, $X_{27}[0] = 1$ is transmitted to the neuron 10.

In an embodiment of the present disclosure, when receiving a pulse signal transmitted by a precursor neuron, the neuron to be ignited may calculate its internal activity threshold at the current moment according to the connection channel between the neuron to be ignited and the precursor neuron as well as the received pulse signal, and may further calculate its internal activity value at the current moment according to the internal activity value increment of the neuron. The output pulse signal of the neuron at the current moment may be calculated according to the internal activity value and the internal activity threshold of the neuron to be ignited.

In an embodiment of the present disclosure, after the neuron to be ignited receives a pulse signal, the manner for the receptive field to process the pulse signal may refer to formula (1). The pulse signal input of the neuron to be ignited may be determined according to the quantity and type of pulse signals received. An example of a calculation formula is as follows:

$$Y_i = \begin{cases} P_s, & \text{only } P_s \\ P_g, & \text{only } P_g \\ P_s + P_g, & \text{both } P_s \text{ and } P_g \\ 0, & \text{no autowave} \end{cases} \qquad (1)$$

Here, $Y_i$ may represent the pulse signal obtained at the current moment according to the pulse signals $X_1$ to $X_K$ received from the neighboring neurons, $P_s$ may represent the source pulse signal, $P_g$ may represent the target pulse signal, and the physical form of the pulse signal may be autowave. When only the source pulse signal is received, the value of the pulse signal of the neuron to be ignited may be the source pulse signal; when only the target pulse signal is received, the value of the pulse signal of the neuron to be ignited may be the target pulse signal. When no pulse signal is received, the value of the pulse signal of the neuron to be ignited may be 0; when the source pulse signal and the target pulse signal are received at the same time, the value of the pulse signal of the neuron to be ignited may be a composite signal of the source pulse signal and the target pulse signal.

In one example, the formula for calculating the internal activity value at the current moment according to the internal activity value increment of the neuron is shown in formula (2):

$$U_i[t] = U_i[t-1] + \Delta U \ (step(Y_i[t] \times N_i) \ \cup \ step(U_i[t-1])) \qquad (2)$$

Here, $U_i[t]$ may represent the internal activity value of the neuron at the current moment, $U_i[t-1]$ may represent the internal activity value of the neuron at the previous moment; $\Delta U$ may represent the internal activity value increment of the neuron, the initial value thereof may be set to be greater than 0, and $\Delta U$ may be calculated according to the internal activity value of the neuron at the current moment and the internal activity value of the neuron at the previous moment; t may represent the current moment, and may be calculated according to the period of the pulse signal; i may represent the serial number of the neuron; $Y_i[t]$ may represent the pulse signal obtained at the current moment according to the pulse signals $X_1$ to $X_K$ of the neighboring neurons, and step() is a step function. $N_i$ may represent the external input, and an example of a calculation formula is as follows:

$$N_i = M_i.$$

Here, $M_i$ may represent an external input signal.

In one example, the formula for calculating the output pulse signal of the neuron at the current moment according to the internal activity value and the internal activity threshold of the neuron to be ignited is shown in formula (3):

$$X_i[t] = step(U_i[t] - \theta_i[t]) = \begin{cases} P_s, & \text{ignited by wave } P_s \\ P_g, & \text{ignited by wave } P_g \end{cases} \qquad (3)$$

Here, $\theta_i[t]$ may represent the internal activity threshold of the neuron at the current moment (which can be marked as $\theta_i$), $P_s$ may represent the source pulse signal sent by the source neuron corresponding to one winder node, and $P_g$ may represent the target pulse signal sent by the target neuron corresponding to one winder node.

In an embodiment of the present disclosure, the internal activity threshold may be obtained according to the pulse signal and the connection channel with the precursor neuron, the current internal activity threshold may be obtained according to the internal activity threshold and the initial internal activity threshold, and the current internal activity value may be obtained according to the pulse signal and the initial internal activity value. Specifically, the manner to calculate the internal activity value at the current moment can refer to formula (2). A manner to calculate the internal activity threshold at the current moment is shown in formula (4):

$$\theta_i[t] = min(\theta_i[t-1], \theta_i^c[t]) + step(X_i[t])V_\theta \qquad (4)$$

Here, $\theta_i[t-1]$ may represent the internal activity threshold of the neuron at the previous moment, $V_\theta$ may be the initial value of the internal activity threshold of the neuron, and the initial value of the internal activity threshold of the neuron may be obtained according to the quantity of edges between neurons.

In one example, the formula for calculating the candidate internal activity threshold at the current moment according to the connection channel between the neuron to be ignited and the precursor neuron as well as the received pulse signal is shown in formula (5):

$$\theta_i^c[t] = min(step(X_k[t])y(e_{k,\,i})), \ k \in [1, 2, \ldots, L(i)] \text{ and } step(X_k[t]) = 1 \qquad (5)$$

Here, $\theta_i^c[t]$ represents the candidate internal activity threshold at the current moment, $X_k[t]$ represents the pulse signal of the precursor neuron received at the current moment, k represents the serial number of the connection channel, $y(e_{k,\,i})$ may represent a parameter value of the connection channel between neurons (which may be an external input value), e may be the serial number of the connection channel, k may be the serial number of the precursor neuron, i may be the serial number of the current neuron to be ignited, and L(i) may represent the total quantity of connection channels. The initial internal activity threshold of the neuron may be set to a relatively large value $V_\theta$. The candidate threshold $\theta_i^c[t]$ may be calculated according to the path length between the neuron that first receives the pulse signal and the current neuron. The candidate threshold is compared with the threshold that has been saved. If the candidate threshold is smaller, the candidate threshold is selected to update the threshold.

In an embodiment of the present disclosure, each time the ignition calculation is performed, the information about the current neuron and its precursor neuron may be obtained. After the last ignition calculation is completed and the ignition is shut down, it is possible to backtrack from the shut-down neuron to the source neuron according to the precursor information to obtain the first path from the source neuron to the shut-down neuron; and similarly, the second path from the target neuron to the shut-down neuron may also be obtained according to the precursor information. The first path and the second path may completely cover all neurons in the DSPCNN. Specifically, the precursor information may be recorded in the form of a list, a queue, an array, etc., which is not limited in the present disclosure.

In an embodiment of the present disclosure, the neurons in the DSPCNN may represent winders or yarn receiving positions of winders in the doffing area, and the connection path between neurons may represent an actual road section between winders or yarn receiving positions of winders in the doffing area. The attributes of the connection path may include length, which may be the actual length of the actual road section or the projection length of the actual road section. The first path and the second path obtained by selecting the source neuron and the target neuron for ignition calculation may respectively represent two doffing branch paths from the winders corresponding to the source neuron and the target neuron through intermediate winders to the winder corresponding to the shut-down neuron. The two doffing branch paths may cover all the winders to be doffed in the doffing area. The above-mentioned two paths obtained after ignition calculation are only examples and not limitations. More paths may be obtained in actual application scenarios. For example, in a case of a circular path, two meeting neurons may be obtained and then four paths may be obtained after ignition calculation, and a total path may be obtained by combining these four paths.

According to the embodiment of the present disclosure, a plurality of paths in the DSPCNN can be obtained by dual source ignition. The simultaneous calculation of the plurality of paths can improve the generation efficiency of paths.

In an embodiment of the present disclosure, whether the neuron to be ignited is ignited may be determined according to the current internal activity value and the internal activity threshold of the neuron to be ignited, and the pulse signal of the neuron to be ignited may also be calculated. The calculation method can refer to formula 3. Specifically, the current internal activity value and the internal activity threshold may be compared. When the current internal activity value is not less than the internal activity threshold, the neuron to be ignited is ignited, and sends the pulse signal to a neighboring neuron to be ignited. For example, the difference between the current internal activity value and the internal activity threshold may be calculated, and the step function may be applied to the difference to obtain a function value. When the function value is greater than 0, the neuron is ignited, and the pulse signal is calculated and transmitted to the neighboring neuron to be ignited of this neuron.

In an embodiment of the present disclosure, the current internal activity value of the neuron to be ignited may represent the total duration estimated to be required for execution of the doffing task to the winder corresponding to the current neuron, and the internal activity threshold may represent the limited duration for execution of the doffing task of the winder corresponding to the current neuron. When the total duration estimated to be required for execution of the doffing task to the current winder is less than the limited duration for execution of the doffing task of the current winder, the neuron to be ignited is ignited, a pulse signal is sent, and a next winder to execute the doffing task is searched for.

According to the embodiment of the present disclosure, the neurons in the DSPCNN can be controlled to be ignited in sequence, and the pulse signal sent by each neuron to other neurons can be calculated, improving the coverage rate of the ignition calculation on the neurons in the DSPCNN.

In an embodiment of the present disclosure, the neuron to be ignited may determine its own ignition state and the type of the pulse signal generated after ignition according to the type of the received pulse signal. The pulse signal sent by the source neuron may be a source pulse signal, and the pulse signal sent by the neuron after receiving the source pulse signal and being ignited to other neurons to be ignited may also be a source pulse signal; the pulse signal sent by the target neuron may be a target pulse signal, and the pulse signal sent by the neuron after receiving the target pulse signal and being ignited to other neurons to be ignited may also be a target pulse signal.

In an embodiment of the present disclosure, if the type of the pulse signal received by the neuron to be ignited is a source pulse signal, the connection input of the neuron to be ignited may be determined according to the source pulse signal. If the type of the pulse signal received by the neuron to be ignited is a target pulse signal, the connection input of the neuron to be ignited may be determined according to the target pulse signal. If the types of pulse signals received by the neuron to be ignited are a source pulse signal and a target pulse signal, the connection input of the neuron to be ignited may be determined according to the source pulse signal and the target pulse signal. If the neuron to be ignited receives no source pulse signal or target pulse signal, the connection input of the neuron to be ignited may be 0 or another set value.

In an embodiment of the present disclosure, the step function at the current moment may be calculated according to the connection input and the feed input of the neuron to be ignited. The internal activity value increment may be calculated according to the step function of the neuron to be ignited at the current moment and the previous moment. The internal activity value of the neuron to be ignited at the current moment may be calculated according to the internal activity value of the neuron to be ignited at the previous moment and the internal activity value increment. Whether the neuron to be ignited is ignited may be determined according to the internal activity value of the neuron to be ignited at the current moment and the internal activity threshold. For example, if the internal activity value of the neuron to be ignited at the current moment is greater than the internal activity threshold, the neuron to be ignited is ignited. Otherwise, the neuron to be ignited is not ignited.

In an embodiment of the present disclosure, if a neuron is ignited under the action of the connection input being a source pulse signal, the neuron also sends a source pulse signal to its neighboring neurons. If a neuron is ignited under the action of the connection input being a target pulse signal, the neuron also sends a target pulse signal to its neighboring neurons. If two kinds of pulse signals are present, meaning that the two kinds of pulse signals meet, the DSPCNN network stops running after the neuron is ignited.

In an embodiment of the present disclosure, when the current neuron to be ignited receives no pulse signal, the neuron may not be ignited, and may not generate a pulse signal sent to other neurons to be ignited. When the current neuron to be ignited receives only a source pulse signal or only a target pulse signal, the neuron may be ignited and generate a pulse signal sent to other neurons to be ignited according to the type of the received pulse signal. When the current neuron to be ignited receives a source pulse signal and a target pulse signal at the same time, the source pulse signal and the target pulse signal meet at the current neuron to be ignited, and ignition may be performed; and the current neuron to be ignited may shut down after ignition and does not generate a pulse signal sent to other neurons to be ignited. When any neuron in the DSPCNN shuts down, the DSPCNN as a whole shuts down. A first path from the source neuron to the shut-down neuron and a second path from the target neuron to the shut-down neuron may be obtained by parsing the received source pulse signal and target pulse signal of the shut-down neuron and backtracking according to the parsing result. Specifically, the first path may represent a doffing branch path from the winder or the doffing area of the winder represented by the source neuron to the winder or the doffing area of the winder represented by the shut-down neuron; and the second path may represent a doffing branch path from the winder or the doffing area of the winder represented by the target neuron to the winder or the doffing area of the winder represented by the shut-down neuron. The first path and the second path both reach the shut-down neuron, and the first path and the second path may be combined to obtain a doffing path covering all winders that need to perform doffing tasks in the doffing workshop.

According to the embodiment of the present disclosure, the neuron to be ignited can be controlled to be ignited and shut down according to the received pulse signal, improving the controllability and stability of the DSPCNN.

In one implementation, the method further includes: recording a precursor relationship when a neuron in the dual source pulse coupled neural network emits a pulse signal.

In an embodiment of the present disclosure, after a neuron in the DSPCNN is ignited, $V_\theta$ may be set to an inhibition value, and the inhibition value is much larger than the initial value of $V_\theta$ and $\theta_i[t]$ obtained by the ignition calculation. When $V_\theta$ is set to the inhibition value, the ignited neuron will not be ignited again after receiving a pulse signal from another neuron, and the internal activity will not be affected by the new pulse signal either, avoiding path crossing or repetition caused by repeated ignition of the neuron. After the neurons in the DSPCNN are ignited, their precursor and successor relationship may be recorded according to the neurons from which the pulse signals come and the connection channels.

According to the embodiment of the present disclosure, the precursor and successor relationship among neurons can be recorded during the ignition process of the DSPCNN to facilitate the generation of the doffing path.

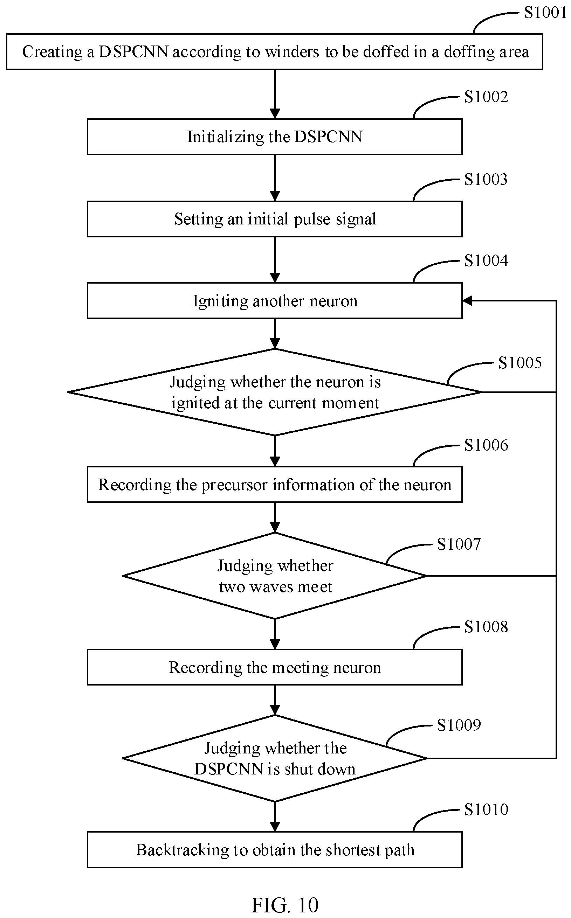

FIG. 10 is a schematic diagram of an algorithm flow for searching the shortest path according to an embodiment of the present disclosure. This flow may include:

S1001: creating a DSPCNN according to winders to be doffed in a doffing area. Firstly, the winders in the doffing area are converted into corresponding winder nodes in the road network topology structure diagram, and then the nodes are mapped into corresponding neurons in the DSPCNN network. Each neuron corresponds to one winder node, the edge connecting every two neurons is a connection channel, and the actual path length between the winders in the doffing area is used as a parameter value of the connection channel of the neurons.

S1002: initializing the DSPCNN. A source neuron $N_E$ and a target neuron $N_T$ are selected from the DSPCNN and ignited simultaneously at the start moment of ignition (i.e., t = 0), and two immediately generated autowaves are propagated simultaneously from the ignition sources to their adjacent neurons. The variable "Meeting" is used to record whether two waves meet, and $N_m$ is used to represent the neuron where the two waves meet. If a pulse emitted by the neuron $N_i$ causes the neuron $N_j$ to be ignited, then $N_i$ is called precursor of $N_j$. The initial internal activity threshold of the neuron may be set to a relatively large value $V_\theta$. When starting to ignite, the attributes of any neuron in the DSPCNN are set as follows: $M_i = 1$, $N_i = M_i$, $Y_i[0] = 0$, $U_i[0] = 0$, $X_i[0] = 0$, $\theta_i[0] = V_\theta$, Meeting = 0; where Meeting is a mark that pulse signals meet in this neuron.

S1003: setting an initial pulse signal. At the time t = 0, the output signal of the source neuron $N_E$ is set as $P_s = X_E[0] = 1$, and the output pulse signal of the target neuron $N_T$ is set as $P_g = X_T[0] = 1$.

S1004: igniting another neuron. $N_P$ may represent a neuron other than the source neuron $N_E$ and target neuron $N_T$ in the DSPCNN. For each neuron, the input signal $Y_i$ received from the precursor neuron may be calculated according to the above formula (1); the internal activity value $U_i[t]$ of the neuron at the current moment may be calculated according to the above formula (2); the output signal $X_i[t]$ sent by the neuron to other neurons may be calculated according to the above formula (3); the internal activity threshold $\theta_i[t]$ of the neuron at the current moment may be calculated according

**EP 4 675 503 A1**

to the above formula (4); and the candidate internal activity threshold $\theta_i^c[t]$ of the neuron at the current moment may be calculated according to the above formula (5).

S1005: judging whether the neuron is ignited at the current moment. If so, execute S1006; and re-execute S1004. If not, whether the neuron is ignited at the current moment may be determined by judging whether the neuron sends a pulse signal at the current moment. For example, if the value of $X_i[t]$ is 1, it is considered that the neuron is ignited at the current moment.

S1006: recording the precursor information of the neuron.

S1007: judging whether two waves meet. For example, if the two waves meet, execute S1008; if the two waves do not meet, execute S1009.

S1008: recording the meeting neuron. Specifically, if the two waves meet, that is, the source pulse signal $P_s$ and the target pulse signal $P_g$ are received by a neuron at the same time, this neuron is a meeting neuron $N_m$. A value may be assigned to $N_m$ according to the serial number of the meeting neuron, and the value of the meeting mark "Meeting" of this neuron is set to 1.

S1009: judging whether the DSPCNN is shut down. If so, execute S1010; if not, execute S1004.

S1010: backtracking to obtain the shortest path. For example, it is possible to backtrack from the meeting neuron $N_m$ to the previous neuron according to the recorded precursor information. Since the meeting neuron receives two pulse signals at the same time, two pieces of precursor information are recorded, and it is possible to backtrack to two precursor neurons. Then the precursor neurons continue to backtrack according to their own recorded precursor information until backtracking to the source neuron $N_E$ and the target neuron $N_T$, to obtain two backtracking paths. The shortest path between the source neuron $N_E$ and the target neuron $N_T$ may be obtained by combining these two backtracking paths.

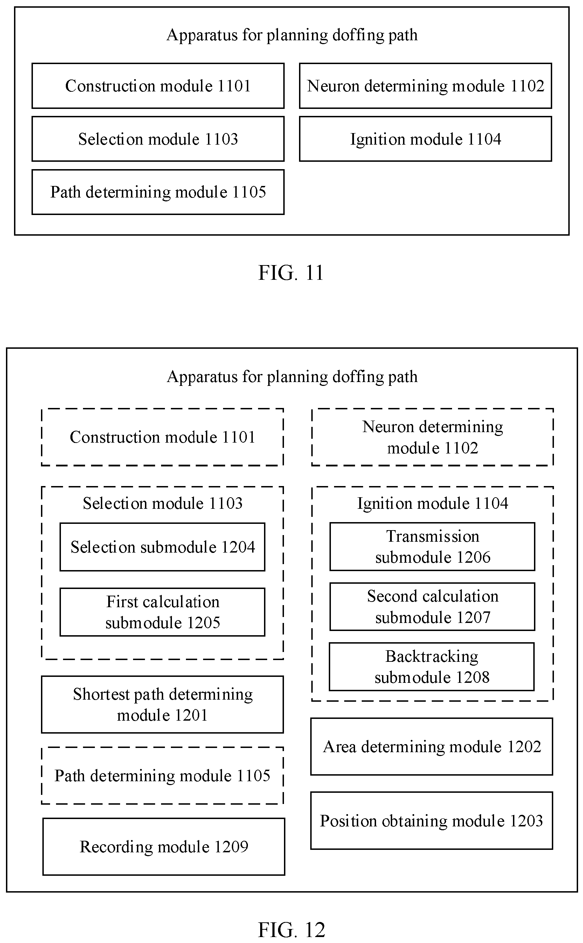

FIG. 11 is a structural schematic diagram of an apparatus for planning a doffing path according to an embodiment of the present disclosure. In one embodiment, this apparatus includes:

a construction module 1101 configured to construct a road network topology structure according to positions of a plurality of winders to be doffed, where the road network topology structure includes a plurality of winder nodes, and one winder node corresponds to one winder;
a neuron determining module 1102 configured to determine a plurality of neurons in a dual source pulse coupled neural network according to the plurality of winder nodes in the road network topology structure, where one winder node corresponds to one neuron;
a selection module 1103 configured to select a source neuron and a target neuron from the plurality of neurons in the dual source pulse coupled neural network;
an ignition module 1104 configured to perform ignition calculation according to the source neuron and the target neuron to obtain a first path corresponding to the source neuron and a second path corresponding to the target neuron; and
a path determining module 1105 configured to determine a doffing path of a winder node in the road network topology structure according to the first path and the second path.

FIG. 12 is a structural schematic diagram of an apparatus for planning a doffing path according to another embodiment of the present disclosure. This apparatus may include one or more features of the above-mentioned apparatus for planning the doffing path. In one implementation, the selection module 1103 is further configured to reselect a source neuron and a target neuron from the plurality of neurons in the dual source pulse coupled neural network; and the ignition module 1104 is further configured to perform ignition calculation according to the reselected source neuron and target neuron to obtain a reselected doffing path. This apparatus further includes:
a shortest path determining module 1201 configured to determine a shortest doffing path according to multiple doffing paths obtained by multiple ignition calculations.

In one implementation, as shown in FIG. 12, this apparatus further includes:

an area determining module 1202 configured to determine a doffing area according to a position of a target device; and
a position obtaining module 1203 configured to obtain positions of the plurality of winders to be doffed in the doffing area according to doffing time of the winders in the doffing area.

In one implementation, the neuron determining module 1102 is further configured to:

construct a connection structure among the plurality of neurons according to a positional relationship of the plurality of winder nodes to obtain connection channels;
obtain values of the connection channels in the connection structure according to path lengths among the plurality of winder nodes; and

set states of all neurons in the dual source pulse coupled neural network to a ready-to-ignite state, and set an initial internal activity value increment, an initial internal activity threshold and an initial internal activity value of each neuron.

In one implementation, as shown in FIG. 12, the selection module 1103 includes:

a selection submodule 1204 configured to randomly select two non-repetitive neurons in the dual source pulse coupled neural network as the source neuron and the target neuron respectively; and
a first calculation submodule 1205 configured to set states of the source neuron and the target neuron to an ignition state.

In one implementation, as shown in FIG. 12, the ignition module 1104 includes:

a transmission submodule 1206 configured to, for a neuron to be ignited that receives a pulse signal, calculate an internal activity value of the neuron to be ignited at a current moment based on the pulse signal and its own internal activity value and internal activity value increment at a previous moment, and determine a state of the neuron to be ignited according to the internal activity value at the current moment and an internal activity threshold;
a second calculation submodule 1207 configured to, when determining that the state of the neuron to be ignited is ignition according to the internal activity value at the current moment and the internal activity threshold, generate a pulse signal of the neuron to be ignited, and update the internal activity threshold of the neuron to be ignited according to the pulse signal of the neuron to be ignited, the pulse signal received by the neuron to be ignited and the internal activity value; and
a backtracking submodule 1208 configured to backtrack from a meeting neuron to the source neuron to obtain the first path, and to the target neuron to obtain the second path; where the meeting neuron is a neuron that receives a source pulse signal and a target pulse signal, the source pulse signal is a pulse signal transmitted by the source neuron, and the target pulse signal is a pulse signal transmitted by the target neuron.

In one implementation, as shown in FIG. 12, this apparatus further includes:
a recording module 1209 configured to record a precursor relationship when a neuron in the dual source pulse coupled neural network emits a pulse signal.

For the description of specific functions and examples of the modules and/or sub-modules of the apparatus of the embodiment of the present disclosure, reference may be made to the relevant description of the corresponding steps in the above-mentioned method embodiments, and details are not repeated here.

In the technical solution of the present disclosure, the acquisition, storage and application of the user's personal information involved are in compliance with relevant laws and regulations, and do not violate public order and good customs.

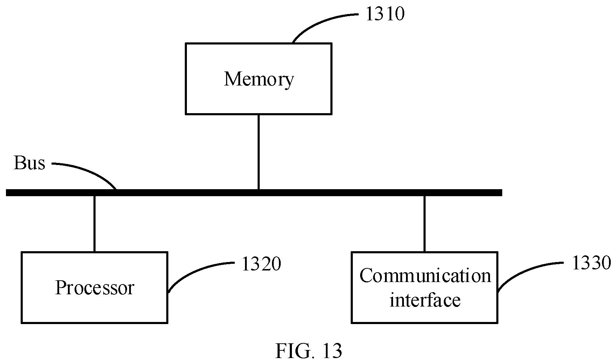

FIG. 13 is a structural block diagram of an electronic device according to an embodiment of the present disclosure. As shown in FIG. 13, the electronic device includes: a memory 1310 and a processor 1320, and the memory 1310 stores a computer program that can run on the processor 1320. There may be one or more memories 1310 and processors 1320. The memory 1310 may store one or more computer programs, and the one or more computer programs cause the electronic device to perform the method provided in the above method embodiment, when executed by the electronic device. The electronic device may also include: a communication interface 1330 configured to communicate with an external device for data interactive transmission.

If the memory 1310, the processor 1320 and the communication interface 1330 are implemented independently, the memory 1310, the processor 1320 and the communication interface 1330 may be connected to each other and complete communication with each other through a bus. The bus may be an Industry Standard Architecture (ISA) bus, a Peripheral Component Interconnect (PCI) bus, or an Extended Industry Standard Architecture (EISA) bus, etc. The bus may be divided into address bus, data bus, control bus, etc. For ease of representation, the buses are represented by only one thick line in FIG. 13, but it does not represent only one bus or only one type of bus.

Optionally, in a specific implementation, if the memory 1310, the processor 1320 and the communication interface 1330 are integrated on one chip, the memory 1310, the processor 1320 and the communication interface 1330 may communicate with each other through an internal interface.

It should be understood that the above-mentioned processor may be a Central Processing Unit (CPU) or other general-purpose processor, a Digital Signal Processor (DSP), an Application Specific Integrated Circuit (ASIC), a Field Programmable Gate Array (FPGA) or other programmable logic device, a discrete gate or transistor logic device, a discrete hardware component, etc. The general-purpose processor may be a microprocessor or any conventional processor, etc. It is worth noting that the processor may be a processor that supports the Advanced RISC Machines (ARM) architecture.

Further, optionally, the above-mentioned memory may include a read-only memory and a random access memory, and may also include a non-volatile random access memory. The memory may be a volatile memory or a non-volatile memory, or may include both a volatile memory and a non-volatile memory. Here, the non-volatile memory may include a Read-Only Memory (ROM), a Programmable ROM (PROM), an Erasable PROM (EPROM), an Electrically EPROM (EEPROM) or a flash memory. The volatile memory may include a Random Access Memory (RAM), which acts as an external cache. By way of illustration and not limitation, many forms of RAMs are available, for example, Static RAM (SRAM), Dynamic Random Access Memory (DRAM), Synchronous DRAM (SDRAM), Double Data Date SDRAM (DDR SDRAM), Enhanced SDRAM (ESDRAM), Synchlink DRAM (SLDRAM) and Direct RAMBUS RAM (DR RAM).

The above embodiments may be implemented in whole or in part by software, hardware, firmware or any combination thereof. When implemented by software, they may be implemented in the form of a computer program product in whole or in part. The computer program product includes one or more computer instructions. When the computer instructions are loaded and executed on a computer, the processes or functions described in the embodiments of the present disclosure are generated in whole or in part. The computer may be a general-purpose computer, a special-purpose computer, a computer network, or other programmable device. The computer instructions may be stored in a computer readable storage medium or transmitted from a computer readable storage medium to another computer readable storage medium. For example, the computer instructions may be transmitted from a website, computer, server or data center to another website, computer, server or data center in a wired (e.g., coaxial cable, optical fiber, Digital Subscriber Line (DSL)) or wireless (e.g., infrared, Bluetooth, microwave, etc.) way. The computer readable storage medium may be any available medium that can be accessed by a computer, or a data storage device such as server or data center that is integrated with one or more available media. The available media may be magnetic media (for example, floppy disk, hard disk, magnetic tape), optical media (for example, Digital Versatile Disc (DVD)), or semiconductor media (for example, Solid State Disk (SSD)), etc. It is worth noting that the computer readable storage medium mentioned in the present disclosure may be a non-volatile storage medium, in other words, may be a non-transitory storage medium.

Those having ordinary skill in the art can understand that all or some of the steps for implementing the above embodiments may be completed by hardware, or may be completed by instructing related hardware through a program. The program may be stored in a computer readable storage medium. The above-mentioned storage medium may be a read-only memory, a magnetic disk or an optical disk, etc.

In the description of the embodiments of the present disclosure, the description with reference to the terms "one embodiment", "some embodiments", "example", "specific example" or "some examples", etc. means that specific features, structures, materials or characteristics described in conjunction with the embodiment or example are included in at least one embodiment or example of the present disclosure. Moreover, the specific features, structures, materials or characteristics described may be combined in a suitable manner in any one or more embodiments or examples. In addition, those skilled in the art can integrate and combine different embodiments or examples and features of different embodiments or examples described in this specification without conflicting with each other.

In the description of the embodiments of the present disclosure, "/" represents or, unless otherwise specified. For example, A/B may represent A or B. The term "and/or" herein only describes an association relation of associated objects, which indicates that there may be three kinds of relations, for example, A and/or B may indicate that only A exists, or both A and B exist, or only B exists.

In the description of the embodiments of the present disclosure, the terms "first" and "second" are only for purpose of description, and cannot be construed to indicate or imply the relative importance or implicitly point out the quantity of technical features indicated. Therefore, the feature defined with "first" or "second" may explicitly or implicitly include one or more features. In the description of the embodiments of the present disclosure, "multiple" means two or more, unless otherwise specified.

The above descriptions are only exemplary embodiments of the present disclosure and not intended to limit the present disclosure. Any modifications, equivalent replacements, improvements and others made within the principle of the present disclosure shall be contained in the protection scope of the present disclosure.

**Claims**

1. A method for planning a doffing path, **characterized by** comprising:

   constructing (S101) a road network topology structure according to positions of a plurality of winders to be doffed, wherein the road network topology structure comprises a plurality of winder nodes, and one winder node corresponds to one winder;
   determining (S102) a plurality of neurons in a dual source pulse coupled neural network according to the plurality of winder nodes in the road network topology structure, wherein one winder node corresponds to one neuron;
   selecting (S103) a source neuron and a target neuron from the plurality of neurons in the dual source pulse coupled neural network;

performing (S104) ignition calculation according to the source neuron and the target neuron to obtain a first path corresponding to the source neuron and a second path corresponding to the target neuron; and

determining (S105) a doffing path of a winder node in the road network topology structure according to the first path and the second path;

wherein the determining a plurality of neurons in a dual source pulse coupled neural network according to the plurality of winder nodes in the road network topology structure, comprises: constructing a connection structure among the plurality of neurons according to a positional relationship of the plurality of winder nodes to obtain connection channels; obtaining values of the connection channels in the connection structure according to path lengths among the plurality of winder nodes; and setting states of all neurons in the dual source pulse coupled neural network to a ready-to-ignite state, and setting an initial internal activity value increment, an initial internal activity threshold and an initial internal activity value of each neuron; and

the performing ignition calculation according to the source neuron and the target neuron to obtain a first path corresponding to the source neuron and a second path corresponding to the target neuron, comprises: for a neuron to be ignited that receives a pulse signal, calculating an internal activity value of the neuron to be ignited at a current moment based on the pulse signal and its own internal activity value and internal activity value increment at a previous moment, and determining a state of the neuron to be ignited according to the internal activity value at the current moment and an internal activity threshold; after determining that the state of the neuron to be ignited is ignition according to the internal activity value at the current moment and the internal activity threshold, generating a pulse signal of the neuron to be ignited, and updating the internal activity threshold of the neuron to be ignited according to the pulse signal of the neuron to be ignited, the pulse signal received by the neuron to be ignited and the internal activity value; and backtracking from a meeting neuron to the source neuron to obtain the first path, and to the target neuron to obtain the second path; wherein the meeting neuron is a neuron that receives a source pulse signal and a target pulse signal, the source pulse signal is a pulse signal transmitted by the source neuron, and the target pulse signal is a pulse signal transmitted by the target neuron.

2. The method of claim 1, further comprising:

reselecting (S401) a source neuron and a target neuron from the plurality of neurons in the dual source pulse coupled neural network;

performing (S402) ignition calculation according to the reselected source neuron and target neuron to obtain a reselected doffing path; and

determining (S403) a shortest doffing path according to multiple doffing paths obtained by multiple ignition calculations.

3. The method of claim 1, further comprising:

determining (S501) a doffing area according to a position of a target device; and

obtaining (S502) positions of the plurality of winders to be doffed in the doffing area according to doffing time of the winders in the doffing area.

4. The method of claim 1, wherein the selecting (S103) a source neuron and a target neuron in the dual source pulse coupled neural network, comprises:

randomly (S701) selecting two non-repetitive neurons in the dual source pulse coupled neural network as the source neuron and the target neuron respectively; and

setting (S702) states of the source neuron and the target neuron to an ignition state.

5. The method of any one of claims 1 to 4, further comprising:

recording a precursor relationship in a case of a neuron in the dual source pulse coupled neural network emits a pulse signal.

6. An apparatus for planning a doffing path, **characterized by** comprising:

a construction module (1101) configured to construct a road network topology structure according to positions of a plurality of winders to be doffed, wherein the road network topology structure comprises a plurality of winder nodes, and one winder node corresponds to one winder;

a neuron determining module (1102) configured to determine a plurality of neurons in a dual source pulse coupled neural network according to the plurality of winder nodes in the road network topology structure, wherein one winder node corresponds to one neuron;

a selection module (1103) configured to select a source neuron and a target neuron from the plurality of neurons in the dual source pulse coupled neural network;

an ignition module (1104) configured to perform ignition calculation according to the source neuron and the target neuron to obtain a first path corresponding to the source neuron and a second path corresponding to the target neuron; and

a path determining module (1105) configured to determine a doffing path of a winder node in the road network topology structure according to the first path and the second path;

wherein the neuron determining module (1102) is further configured to: construct a connection structure among the plurality of neurons according to a positional relationship of the plurality of winder nodes to obtain connection channels; obtain values of the connection channels in the connection structure according to path lengths among the plurality of winder nodes; and set states of all neurons in the dual source pulse coupled neural network to a ready-to-ignite state, and set an initial internal activity value increment, an initial internal activity threshold and an initial internal activity value of each neuron; and

the ignition module (1104) comprises:

a transmission submodule (1206) configured to, for a neuron to be ignited that receives a pulse signal, calculate an internal activity value of the neuron to be ignited at a current moment based on the pulse signal and its own internal activity value and internal activity value increment at a previous moment, and determine a state of the neuron to be ignited according to the internal activity value at the current moment and an internal activity threshold;

a second calculation submodule (1207) configured to, after determining that the state of the neuron to be ignited is ignition according to the internal activity value at the current moment and the internal activity threshold, generate a pulse signal of the neuron to be ignited, and update the internal activity threshold of the neuron to be ignited according to the pulse signal of the neuron to be ignited, the pulse signal received by the neuron to be ignited and the internal activity value; and

a backtracking submodule (1208) configured to backtrack from a meeting neuron to the source neuron to obtain the first path, and to the target neuron to obtain the second path;

wherein the meeting neuron is a neuron that receives a source pulse signal and a target pulse signal, the source pulse signal is a pulse signal transmitted by the source neuron, and the target pulse signal is a pulse signal transmitted by the target neuron.

7. The apparatus of claim 6, wherein the selection module (1103) is further configured to reselect a source neuron and a target neuron from the plurality of neurons in the dual source pulse coupled neural network; the ignition module is further configured to perform ignition calculation according to the reselected source neuron and target neuron to obtain a reselected doffing path; and the apparatus further comprises:

a shortest path determining module (1201) configured to determine a shortest doffing path according to multiple doffing paths obtained by multiple ignition calculations.

8. The apparatus of claim 6, further comprising:

an area determining module (1202) configured to determine a doffing area according to a position of a target device; and

a position obtaining module (1203) configured to obtain positions of the plurality of winders to be doffed in the doffing area according to doffing time of the winders in the doffing area.

9. The apparatus of claim 6, wherein the selection module (1103) comprises:

a selection submodule (1204) configured to randomly select two non-repetitive neurons in the dual source pulse coupled neural network as the source neuron and the target neuron respectively; and

a first calculation submodule (1205) configured to set states of the source neuron and the target neuron to an ignition state.

10. The apparatus of any one of claims 6 to 9, further comprising:

a recording module (1209) configured to record a precursor relationship in a case of a neuron in the dual source pulse coupled neural network emits a pulse signal.

**11.** A non-transitory computer-readable storage medium storing a computer instruction thereon, wherein the computer instruction is used to cause a computer to execute the method of any one of claims 1 to 5.

**12.** A computer program product comprising a computer program, wherein the computer program implements the method of any one of claims 1 to 5, when executed by a processor.

S101

Constructing a road network topology structure according to positions of a plurality of winders to be doffed, where the road network topology structure includes a plurality of winder nodes, and one winder node corresponds to one winder

S102

Determining a plurality of neurons in a dual source pulse coupled neural network according to the plurality of winder nodes in the road network topology structure, where one winder node corresponds to one neuron

S103

Selecting a source neuron and a target neuron from the plurality of neurons in the DSPCNN

S104

Performing ignition calculation according to the source neuron and the target neuron to obtain a first path corresponding to the source neuron and a second path corresponding to the target neuron

S105

Determining a doffing path of a winder node in the road network topology structure according to the first path and the second path

FIG. 1

Neuron

| Receptive field | Modulation field | Pulse generator |
| --- | --- | --- |
| | | |

FIG. 2

●     Neuron

———     First path

– – –     Second path

FIG. 3

S401

Reselecting a source neuron and a target neuron from the plurality of neurons in the DSPCNN

S402

Performing ignition calculation according to the reselected source neuron and target neuron to obtain a reselected doffing path

S403

Determining a shortest doffing path according to multiple doffing paths obtained by multiple ignition calculations

FIG. 4

S501

Determining a doffing area according to a position of a target device

S502

Obtaining positions of the plurality of winders to be doffed in the doffing area according to doffing time of the winders in the doffing area

FIG. 5

S101

Constructing a road network topology structure according to positions of a plurality of winders to be doffed, where the road network topology structure includes a plurality of winder nodes, and one winder node corresponds to one winder

S601

Constructing a connection structure among the plurality of neurons according to a positional relationship of the plurality of winder nodes to obtain connection channels

S602

Obtaining values of the connection channels in the connection structure according to path lengths among the plurality of winder nodes

S603

Setting states of all neurons in the DSPCNN to a ready-to-ignite state, and setting an initial internal activity value increment, an initial internal activity threshold and an initial internal activity value of each neuron

S103

Selecting a source neuron and a target neuron from the plurality of neurons in the DSPCNN

S104

Performing ignition calculation according to the source neuron and the target neuron to obtain a first path corresponding to the source neuron and a second path corresponding to the target neuron

S105

Determining a doffing path of a winder node in the road network topology structure according to the first path and the second path

FIG. 6

S101

Constructing a road network topology structure according to positions of a plurality of winders to be doffed, where the road network topology structure includes a plurality of winder nodes, and one winder node corresponds to one winder

S102

Determining a plurality of neurons in a dual source pulse coupled neural network according to the plurality of winder nodes in the road network topology structure, where one winder node corresponds to one neuron

S701

Randomly selecting two non-repetitive neurons in the DSPCNN as the source neuron and the target neuron respectively

S702

Setting states of the source neuron and the target neuron to an ignition state

S104

Performing ignition calculation according to the source neuron and the target neuron to obtain a first path corresponding to the source neuron and a second path corresponding to the target neuron

S105

Determining a doffing path of a winder node in the road network topology structure according to the first path and the second path

FIG. 7

S801

For a neuron to be ignited that receives a pulse signal, calculating an internal activity value of the neuron to be ignited at a current moment based on the pulse signal and its own internal activity value and internal activity value increment at a previous moment, and determining a state of the neuron to be ignited according to the internal activity value at the current moment and an internal activity threshold

S802

When determining that the state of the neuron to be ignited is ignition according to the internal activity value at the current moment and the internal activity threshold, generating a pulse signal of the neuron to be ignited, and updating the internal activity threshold of the neuron to be ignited according to the pulse signal of the neuron to be ignited, the pulse signal received by the neuron to be ignited and the internal activity value

S803

Backtracking from a meeting neuron to the source neuron to obtain the first path, and to the target neuron to obtain the second path; where the meeting neuron is a neuron that receives a source pulse signal and a target pulse signal, the source pulse signal is a pulse signal transmitted by the source neuron, and the target pulse signal is a pulse signal transmitted by the target neuron

FIG. 8

FIG. 9

S1001

Creating a DSPCNN according to winders to be doffed in a doffing area

S1002

Initializing the DSPCNN

S1003

Setting an initial pulse signal

S1004

Igniting another neuron

S1005

Judging whether the neuron is ignited at the current moment

S1006

Recording the precursor information of the neuron

S1007

Judging whether two waves meet

S1008

Recording the meeting neuron

S1009

Judging whether the DSPCNN is shut down

S1010

Backtracking to obtain the shortest path

FIG. 10

**Apparatus for planning doffing path**

| | |
|---|---|
| Construction module 1101 | Neuron determining module 1102 |
| Selection module 1103 | Ignition module 1104 |
| Path determining module 1105 | |

FIG. 11

**Apparatus for planning doffing path**

Construction module 1101

Neuron determining module 1102

Selection module 1103
- Selection submodule 1204
- First calculation submodule 1205

Ignition module 1104
- Transmission submodule 1206
- Second calculation submodule 1207
- Backtracking submodule 1208

Shortest path determining module 1201

Path determining module 1105

Recording module 1209

Area determining module 1202

Position obtaining module 1203

FIG. 12

1310

Memory

Bus

Processor 1320

Communication interface 1330

FIG. 13

Europäisches
Patentamt
European
Patent Office
Office européen
des brevets

# EUROPEAN SEARCH REPORT

**Application Number**

EP 25 18 3663

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | LI XIAOJUN ET AL: "Self-adaptive autowave pulse-coupled neural network for shortest-path problem", ARXIV,, vol. 115, 8 February 2013 (2013-02-08), pages 63-71, XP028543500, DOI: 10.1016/J.NEUCOM.2012.12.030 * abstract; figures 1-3 * * Sections 1-3 * | 1-12 | INV. G06N3/049 B65H67/06 B65H67/04 |
| | ----- | | |
| A | CN 115 834 393 A (BEIJING LYNXI TECH CO LTD) 21 March 2023 (2023-03-21) * abstract; figures 1, 4 * * paragraphs [0001] - [0013], [0033] - [0042], [0057], [0063], [0088] - [0092] * | 1-12 | |
| | ----- | | |

**TECHNICAL FIELDS SEARCHED (IPC)**

G06N
B65H

The present search report has been drawn up for all claims

| Place of search | Date of completion of the search | Examiner |
|---|---|---|
| The Hague | 9 October 2025 | Houtgast, Ernst |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 18 3663

This annex lists the patent family members relating to the patent documents cited in the above-mentioned European search report.
The members are as contained in the European Patent Office EDP file on
The European Patent Office is in no way liable for these particulars which are merely given for the purpose of information.

09-10-2025

| Patent document cited in search report | Publication date | Patent family member(s) | Publication date |
|---|---|---|---|
| CN 115834393 A | 21-03-2023 | NONE | |

EPO FORM P0459

For more details about this annex : see Official Journal of the European Patent Office, No. 12/82